# EUROPEAN PATENT SPECIFICATION

(11) **EP 3 098 557 B1**
(45) Date of publication and mention of the grant of the patent: **27.03.2019**
(21) Application number: 15169212.6
(22) Date of filing: 26.05.2015
(51) Int. Cl.: F28F 13/00, F28D 15/02, H01L 23/40, H01L 23/433, H05K 7/20

(54) **DYNAMIC HEAT CONDUCTION SYSTEM**
SYSTEM ZUR DYNAMISCHEN WÄRMELEITUNG
SYSTÈME DE CONDUCTION THERMIQUE DYNAMIQUE

(43) Date of publication of application: 30.11.2016
(73) Proprietor: Advantech Co., Ltd., Taipei 114 (TW)
(72) Inventor: HSIEH, Chi-Hung, 114 Taipei (TW)
(74) Representative: Charrier Rapp & Liebau

(56) References cited:
- EP-A1- 2 634 798
- EP-A2- 1 638 143
- GB-A- 2 197 538
- US-A1- 2007 030 656
- US-A1- 2015 062 827
- DATABASE EPODOC [Online] EUROPEAN PATENT OFFICE, THE HAGUE, NL; 6 March 2002 (2002-03-06), XP002750008, Database accession no. CN-01224530-U -& CN 2 480 986 Y (TAIDA ELECTRONIC IND CO LTD [CN]) 6 March 2002 (2002-03-06)

## Description

### BACKGROUND OF THE INVENTION

### FIELD OF THE INVENTION

This application relates to a dynamic heat conduction system. More particularly, this application relates to a dynamic heat conduction system applied to computer apparatus.

### DESCRIPTION OF THE PRIOR ART

In computer apparatus, it generally used a heat conduction device with a heat conduction block to maintain the operation at a suitable temperature. The heat energy can be rapidly transferred from the electronic component to the heat conduction device by making the heat conduction block be closely contact to the electronic component that produced mass of heat.

For making the heat conduction block of the heat conduction device be closely contacted to the processor, one traditional method is disposing a thermal pad in the gap between the heat conduction block and the processor. The thermal pad produces an amount of deformation when the heat conduction block contacts to the processor so that the thermal pad closely contacts to the heat conduction block and the processor simultaneously. However, such a thermal pad generally has a high thermal resistance and the heat conduction device cannot adapt to different heights of electronic components while the thickness of the thermal pad is decreased as low as possible. Therefore, traditionally, people have to design different heat conduction devices for a variety of electronic components of different heights, which leads to a high cost. In addition, such a thermal pad has no buffering capacity that it easily causes damages to the electronic components when being subject to an external force or vibration.

Please refer to the heat conduction structure shown in FIG. 1 (Taiwan Utility Patent No. M451797) which stands for another traditional method for heat conduction block, which discloses a heat conduction block 3 having downward displacement to exert force to a connecting portion 21 of the heat conduction pipe 2 and the resilient positioning plate 4 when the electronic components and the heat conduction blocks of the circuit board (Not shown) contact to each other. The heat conduction block 3 can closely contact to an electronic component in one side and the heat conduction pipe 2 in other side simultaneously. The heat conduction block and the heat conduction pipe are secured with spring screws to complete a heat conduction structure with low thermal resistance. However, such a traditional method for heat conduction block has the following disadvantages: the distortion of heat pipes may cause heat pipes failure; the cost of heat pipes and spring screws is higher; it is difficult to assemble the electronic components in different height; it is difficult to maintain the heat conduction blocks and the electronic components contacting closely; and the heat conduction structure has no buffering capacity so that it is easy to cause damage to the electronic components in the vibration environment.

Furthermore, refer to the heat conduction structure of the United Stated Patent No. 2007/030656 A1, which stands for another traditional method for a heat conduction block having a external case panel, a base portion, a translational portion and a spring. The translational portion has a piston for fitting into the cylindrical cavity of the base portion, and the spring urges the translational portion.

Additionally, refer to the heat conduction structure of the United Stated Patent No. 2015/0062827 A1, which stands for another traditional method for a heat sink having a fixing unit with a plurality of screw holes and a heat dissipation unit with a pair of communication holes. The communication holes are selectively communicated with any of the plurality of screw holes according to the sliding position of the heat dissipation unit with respect to the fixing unit.

In addition, for the requirement of simultaneously processing heat conduction of a plurality of electronic components, the heat conduction device of the prior art is providing a corresponding heat conduction device for each electronic components. Therefore, the heat conduction block of the heat conduction device of the prior art obviously has inconveniences and defects which can be improved.

### SUMMARY OF THE INVENTION

In view of the problems of the traditional heat conduction blocks that described above, the present invention can avoid the damage of the heat conduction units and the electronic components caused by an external force when they are assembled, can keep the heat conduction units and the electronic components contacting closely at the same time, and can thus simplifying the process of a plurality of the electronic components which provided a plurality of the heat conduction units.

In view of the purpose of the present invention, a dynamic heat conduction system is provided. The dynamic heat conduction system comprises a base, a heat conduction block, a resilient unit and at least one securing unit. The base has a base surface and an inner side wall which defines at least two base securing holes having a base securing hole length along the direction of a normal line to the base surface. The heat conduction block comprises a heat conduction side wall and a heat conduction surface, the heat conduction side wall being opposite to the inner side wall of the base and a gap is defined between the heat conduction side wall and the inner side wall of the base. The heat conduction side wall comprises at least two heat conduction block securing holes at positions respectively corresponding to those of the base securing holes, the heat conduction block securing holes have a heat conduction block securing hole length along the direction of a normal line to the base surface of the base. The resilient unit has one end being disposed on the base surface of the base and the other end being opposite to the base surface of the base and being engaged with the heat conduction block, so that the heat conduction block is disposed in the base and the heat conduction surface remains outside the base. At least one securing unit has at least one portion being secured to the heat conduction block securing holes respectively and at least another one of the other portions being disposed in the base securing holes respectively, the securing unit has a securing unit width along the direction of a normal line to the base surface of the base. The base securing hole length is greater than the securing unit width and the securing unit width is greater than or equal to the heat conduction block securing hole length, so that the heat conduction block is movable in the direction of a normal line to the heat conduction surface and at least one portion thereof is restricted within the base.

Optionally, the dynamic heat conduction system comprises a heat conduction fluid disposed in the gap between the heat conduction side wall and the inner side wall of the base. Further, the heat conduction block has at least one groove on the heat conduction side wall for accommodating the heat conduction fluid.

Still, the dynamic heat conduction system comprises a hole penetrating the heat conduction block and forming the at least two heat conduction block securing holes on the heat conduction side wall.

In view of the purpose of the present invention, another dynamic heat conduction system is provided. The dynamic heat conduction system comprises a heat conduction board, a plurality of bases, a plurality of heat conduction blocks, a plurality of resilient units and a plurality of securing units. The heat conduction board covers a plurality of electronic components. The plurality of bases are disposed respectively on the heat conduction board at positions corresponding to the electronic components and respectively comprise a base surface and an inner side wall which defines at least two base securing holes having a base securing hole length along the direction of a normal line to the base surface. The plurality of heat conduction blocks are disposed respectively in the bases and respectively comprise a heat conduction side wall and a heat conduction surface, the heat conduction side walls respectively are opposite to the inner side wall of the bases and between the heat conduction side walls and the inner side wall of the bases respectively comprise a gap. The heat conduction side comprises at least two heat conduction block securing holes at positions respectively corresponding to those of the base securing holes, the heat conduction block securing holes respectively have a heat conduction block securing hole length along the direction of a normal line to the base surface of the bases. The plurality of resilient units are disposed respectively in the bases and respectively have one end being disposed on the base surface of the bases and the other end respectively being opposite to the base surface of the bases and are engaged with the heat conduction blocks, so that the heat conduction blocks are disposed respectively in the bases and the heat conduction surfaces remain outside the bases. The plurality of securing units are disposed respectively in the bases, respectively have at least one portion being secured to the heat conduction block securing holes and at least another portion being disposed in the base securing holes, and respectively have a securing unit width along the direction of a normal line to the base surface of the bases respectively. The base securing holes length are greater respectively than the securing units width and the securing units width are greater respectively than or equal to the heat conduction block securing holes length so that the heat conduction blocks are movable in the direction of a normal line to the heat conduction surface respectively and at least one portion thereof is restricted within the bases.

Optionally, the dynamic heat conduction system comprises a heat conduction fluid disposed in the gap between the heat conduction side wall and the inner side wall of the base. Further optionally, the plurality of heat conduction blocks have at least one groove on the heat conduction side walls for accommodating the heat conduction fluid.

Still, the plurality of heat conduction blocks have a hole penetrating the heat conduction blocks and forming the at least two heat conduction block securing holes on the heat conduction side wall.

Further, for corresponding to the heights of the plurality of electronic components, the plurality of bases have different heights of bases respectively, the plurality of heat conduction blocks have different heights of heat conduction blocks respectively or the plurality of resilient units have different heights of unit or different resilient coefficients respectively.

Further, for corresponding to a contact surface area of the plurality of electronic components, the plurality of heat conduction blocks have different heat conduction surface areas respectively or the plurality of resilient units have different resilient unit areas respectively.

Further, the plurality of bases can be secured on the heat conduction boards with a post processing nickel and the heat conduction board. The bases can also be secured on the heat conduction boards with screws.

According to the dynamic heat conduction system of the present invention, a buffering effect can be provided to avoid causing damage of the electronic components and the heat conduction system by external force and keeping the heat conduction system and the electronic components be contacted closely to achieve better heat conduction effect. In addition, according to the dynamic heat conduction system of the present invention, the heat conduction blocks can be provided to the plurality of electronic components respectively to achieve contacting closely and better heat conduction effect. The assembly process of the heat conduction unit and the plurality of electronic components can be simplified.

### BRIEF DESCRIPTION OF THE DRAWINGS

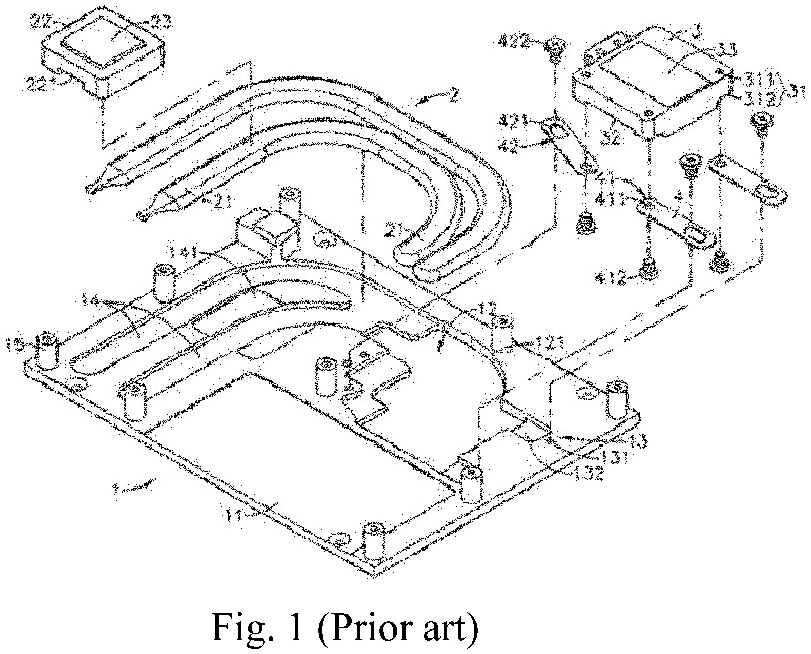

Fig. 1 is a heat conduction structure of the prior art.
Fig. 2 is an exploded view of an exemplary embodiment according to the dynamic heat conduction system of the present invention.
Fig. 3 is a top view of the embodiment shown in Fig. 2.
Fig. 4 is a sectional view drawn along Line A-A as shown in Fig. 3.
Fig. 5 is a top view of another embodiment according to the dynamic heat conduction system of the present invention.
Fig. 6 is a sectional view drawn along Line B-B as shown in Fig. 5.
Fig. 7 is a perspective view of another embodiment according to the dynamic heat conduction system of the present invention.

### DETAILED DESCRIPTION OF THE PREFERRED EMBODIMENTS

The following text is described by exemplary embodiments of the present invention and with reference to the drawings.

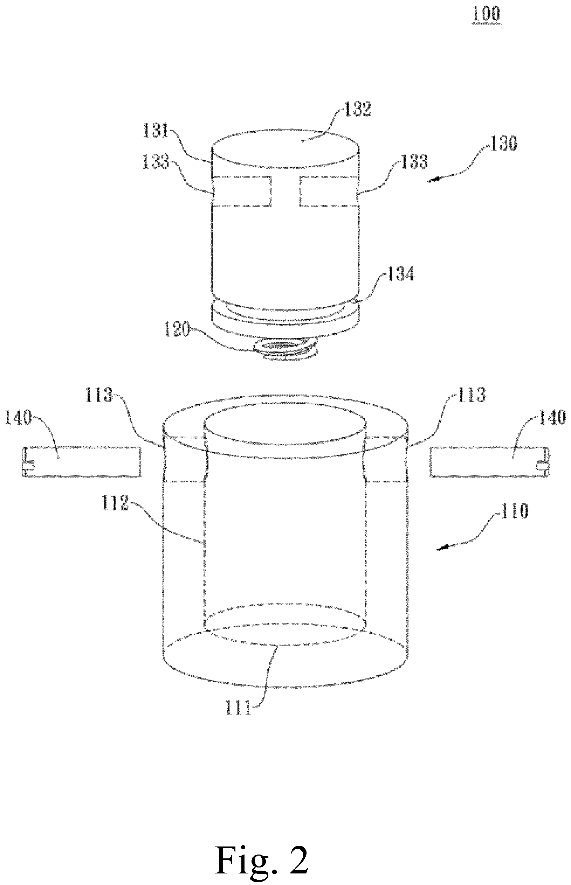

Please refer to Fig. 2, which is an exploded view of a dynamic heat conduction system 100 according to the present invention. A base 110, a resilient unit 120, a heat conduction block 130 and structures of securing units 140 are depicted. The base 110 comprises a base surface 111, an inner side wall 112 and base securing holes 113 on the inner side wall 112. One end of the resilient unit 120 is engaged with the base surface 111 of the base 110 and the other end of the resilient unit 120 is engaged with the heat conduction block 130. The heat conduction block 130 comprises a heat conduction side wall 131, a heat conduction surface 132, heat conduction block securing holes 133 and a groove 134.

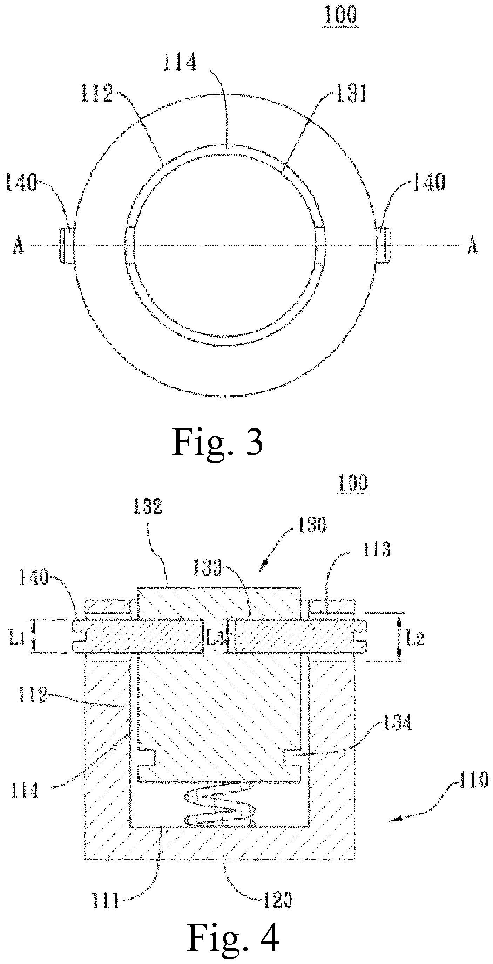

Please refer to Fig. 3, which is a top view of the dynamic heat conduction system 100 according to the present invention. The inner side wall 112 of the base 110 is opposite to the heat conduction side wall 131 of the heat conduction block 130 and a gap 114 is defined between the inner side wall 112 and the heat conduction side wall 131. Although the dynamic heat conduction system 100 of the embodiment is circular in the top view, the heat conduction block and base of dynamic heat conduction system of the present invention in a top view can also be elliptical, rectangular, etc. or have different size of heat conduction surface areas or base shedding surface areas so as to adapt to different shapes or areas of the electronic components. Preferably, the resilient unit of the dynamic heat conduction system of the present invention can also has a different resilient unit area in the direction of a normal line to the heat conduction surface to fit using different shapes or areas of the electronic components.

Please refer to Fig. 4, which is a sectional view drawn along line A-A shown in Fig. 3. A link relation of the various components after assembled in the dynamic heat conduction system 100 is depicted. One portion of the securing units 140 are secured to the heat conduction block securing holes 133, another portion of the securing units 140 are disposed in the base securing holes 113 and the securing units 140 have a securing unit width L1 along the direction of a normal line to the base surface 111. The base securing holes 113 have a base securing hole length L2 along the direction of a normal line to the base surface 111. The heat conduction block securing holes 133 have a heat conduction block securing hole length L3 along the direction of a normal line to the base surface 111. The condition of L2> L1 ≧ L3 must be satisfied, so that at least one portion of the heat conduction block 130 is restricted within the base 110 by the securing unit 140 and the base securing holes 113 when the securing units 140 and the heat conduction block 130 are movable in the direction of a normal line to the base surface 111.

The heat conduction surface 132 of the heat conduction block 130 can be closely contacted to a electronic component, so that the heat generated by the electronic component via the heat conduction surface 132 pass through the heat conduction block 130, the heat conduction side wall 131 and the inner side wall 112 of the base 110, and to the base 110. Preferably, an appropriate amount of heat conduction fluid which disposed in the gap 114 of dynamic heat conduction system 100 can optionally be provided, to increase the thermal conductivity between the heat conduction side wall 131 and the inner side wall 112 of the base 110. The heat conduction fluid can be a heat conduction paste known for one skilled in the art.

The groove 134 on the heat conduction side wall 131 can be used as a buffer space for a heat conduction fluid in the gap 114 when the present embodiment optionally provide the heat conduction fluid in the gap 114 of the dynamic heat conduction system 100. The groove 134 accommodates excessive heat conduction fluid when the heat conduction fluid in the gap 114 is in excess. The heat conduction fluid accommodating in the groove 134 provides to the gap 114 when the heat conduction fluid in the gap 114 is insufficient. In this way, the dynamic heat conduction system 100 of the present application can maintain an appropriate amount of heat conduction fluid in the gap 114 so that it can keep better heat conduction effects between the heat conduction side wall 131 and the inner side wall 112 of the base 110. Preferably, the dynamic heat conduction system of the present invention can optionally provide two or more grooves or a threaded groove on the heat conduction side wall to increase the cushioning effect for the heat conduction fluid. More preferably, the dynamic heat conduction system of the present invention can optionally not provide grooves on the heat conduction side wall to increase the contact area between the heat conduction side wall and the inner side wall of the base.

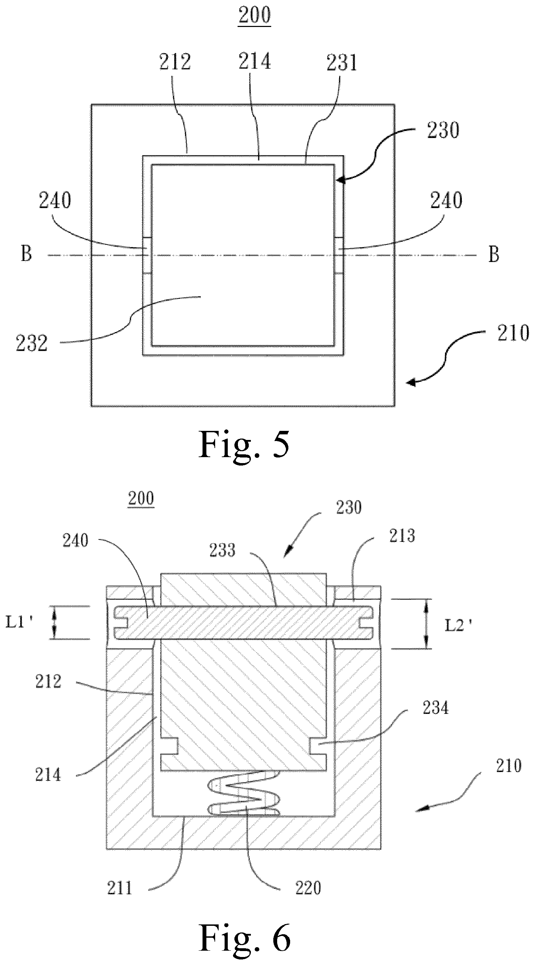

Then another embodiment of the present invention is described. Please refer to Fig. 5, which is a top view of a dynamic heat conduction system 200 according to the present invention. A heat conduction block 230 and a base 210 are shown as rectangle in the top view. The heat conduction block and the base of the dynamic heat conduction system in the top view can also be, for example, oval, circular, etc. or heat conduction surface areas or the base shedding surface areas which have different sizes to conform to the use of electronic components which having different shapes or contact surface areas. Preferably, resilient units of the dynamic heat conduction system can also have a different resilient unit area along the direction of a normal line to the heat conduction surface to conform to the use of electronic components which have different shapes or areas.

Please refer to Fig. 6, which is a sectional view drawn along line B-B as shown in Fig. 4. The heat conduction block 230 has a hole 233 penetrating the heat conduction block and forming two heat conduction block securing holes on the heat conduction side wall (Not shown). In the dynamic heat conduction system 200, a single securing unit 240 penetrates the heat conduction block 230 and be secured in the hole 233, and the both ends of securing unit 240 have at least one part be disposed in base securing holes 213 respectively. In addition, the securing unit 240 has a securing unit width L1' along the direction of a normal line to a base surface 211; the base securing holes 213 has a base securing hole length L2' along the direction of a normal line to the base surface 211. The condition of L2' > L1' must be satisfied, so that at least one portion of the heat conduction block 230 is restricted within the base 210 by the securing unit 240 and the base securing holes 213 when the securing unit 240 and the heat conduction block 230 are movable in the direction of a normal line to the base surface 211. The dynamic heat conduction system of the present invention can optionally use two securing units disposing respectively on two heat conduction block securing holes which on the heat conduction side wall to reach the effect that at least one portion is restricted within the base.

The heat conduction surface 232 of the heat conduction block 230 can be closely contacted to a electronic component so that the heat generated by the electronic component via the heat conduction surface 232 passes through the heat conduction block 230, a heat conduction side wall 231 and a inner side wall 212 of the base 210 and transfers to the base 210. Preferably, the present invention can optionally provide an appropriate amount of heat conduction fluid which disposed in a gap 214 of dynamic heat conduction system 200 to increase the thermal conductivity between the heat conduction side wall 231 and the inner side wall 212 of the base 210. The heat conduction fluid can be a heat conduction paste known in the skill field.

The groove 234 on the heat conduction side wall 231 can be used as a buffer space for a heat conduction fluid in the gap 214 when the present embodiment optionally provide the heat conduction fluid in the gap 214 of the dynamic heat conduction system 200. The groove 234 accommodates excessive heat conduction fluid when the heat conduction fluid in the gap 214 is in excess. The heat conduction fluid accommodating in the groove 234 provides to the gap 214 when the heat conduction fluid in the gap 214 is insufficient. In this way, the dynamic heat conduction system 200 of the present application can maintain an appropriate amount of heat conduction fluid in the gap 214 so that it can keep better heat conduction effects between the heat conduction side wall 231 and the inner side wall 212 of the base 210. The dynamic heat conduction system of the present invention can optionally provide two or more grooves or a threaded groove on the heat conduction side wall to increase the cushioning effect for the heat conduction fluid. More preferably, the dynamic heat conduction system of the present invention can optionally not provide grooves on the heat conduction side wall, in order to increase the contact area between the heat conduction side wall and the inner side wall of the base.

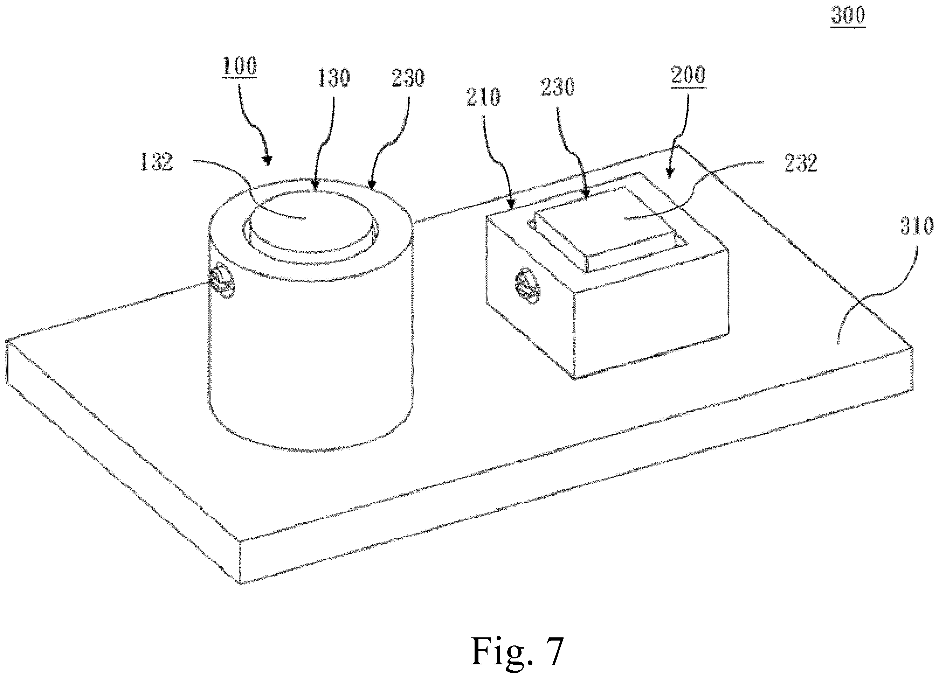

Please refer to Fig. 7, which is a perspective view of a dynamic heat conduction system 300 according to the present invention. The dynamic heat conduction system 100 as similar as shown in Figs. 2, 3 & 4 and the dynamic heat conduction system 200 as shown in Figs. 5 & 6 are disposed on the heat conduction board 310. The dynamic heat conduction systems 100, 200 are used a welded way of post processing nickel securing on the heat conduction board. Preferably, the present invention can also uses others, screws, for example, to secure the dynamic heat conduction system on the heat conduction board. In the present embodiment, by the heat conduction block 130, 230 of the dynamic heat conduction system 100, 200 can be moving along the direction of a normal line to the base. The dynamic heat conduction system 300 can be more closely contacting with two electronic components with different heights and avoid causing the condition of electronic components damaged which under pressure at the time of assembly or under external force after the assembly. In addition, the heat conduction surface 132 and 232 of the heat conduction block 130 and 230 respectively have shapes of circular and rectangular and different heat conduction surface areas, the base 110 and 120 have different shedding surface areas and the resilient unit respectively have different resilient unit areas so that the dynamic heat conduction system 300 can closely contact the electronic components having different contact surface areas and shapes at the same time. The bases have different heights, and the heat conduction blocks have different heights and the resilient unit have different heights and different resilient coefficients, so that the dynamic heat conduction system 300 can closely contact the electronic components having different heights at the same time. The present invention can be previously disposed a plurality of fillisters on the heat conduction board for receiving a plurality of dynamic heat conduction systems in the heat conduction board to increase the contact area of the base with the heat conduction board of the dynamic heat conduction system to achieving better heat conduction effects.

The present invention is not limited to providing two dynamic heat conduction systems on the heat conduction board. The one in the scope of the invention having the relevant art(s) can be learned that the invention can provide a single or a plurality of dissimilar dynamic heat conduction systems on the heat conduction board naturally by the contents of the invention disclosed. Preferably, the invention can provide the resilient units having different resilient coefficients or provide the dynamic heat conduction systems having different shapes, heights or areas which corresponding to electronic components with different heights, shapes or areas so that to achieve the purpose which having better heat conduction effects for a plurality of different electronic components at the same time, simplifying the complexity of manufacture and avoiding the electronic components damaged under external force in the assembly process or after the assembly.

After a detailed description of the preferred embodiments of the present invention, one skilled in the relevant art(s) can clearly understand that it can process various changing and modifying without departing from the scope of the invention. Therefore, the present invention should not be limited by any of the above-described exemplary embodiments in the specification.

## Claims

1. A dynamic heat conduction system (100; 200; 300), comprising:
a base (110; 210) comprising a base surface (111; 211) and an inner side wall (112; 212) which defines at least two base securing holes (113; 213) having a base securing hole length (L2; L2') along the direction of a normal line to the base surface (111; 211);
a heat conduction block (130; 230) comprising a heat conduction side wall (131; 231) and a heat conduction surface (132; 232), the heat conduction side wall (131; 231) being opposite to the inner side wall (112; 212) of the base and defining at least two heat conduction block securing holes (133; 233) at positions respectively corresponding to those of the base securing holes (113; 213), the heat conduction block securing holes (133; 233) having a heat conduction block securing hole length (L3) along the direction of a normal line to the base surface (111; 211) of the base (110; 210);
a resilient unit (120; 220) having one end being disposed on the base surface (111; 211) of the base (110; 210) and the other end being opposite to the base surface (111; 211) of the base (110; 210) and being engaged with the heat conduction block (130; 230), so that the heat conduction block (130; 230) is disposed in the base (110; 210) and the heat conduction surface (132; 232) remains outside the base (110; 210); and
at least one securing unit (140; 240) having at least one portion being secured to the heat conduction block securing holes (133; 233) respectively and at least another one of the other portions being disposed in the base securing holes (113; 213) respectively, the securing unit (140; 240) having a securing unit width (L1; L1') along the direction of a normal line to the base surface (111; 211) of the base (110; 210),
wherein the base securing hole length (L2; L2') is greater than the securing unit width (L1; L1') and the securing unit width (L1; L1') is greater than or equal to the heat conduction block securing hole length (L3), so that the heat conduction block (130; 230) is movable in the direction of a normal line to the heat conduction surface (132; 232) and at least one portion thereof is restricted within the base (110, 210).

2. The dynamic heat conduction system (100; 200; 300) of claim 1, wherein a gap (114; 214) accommodating a heat conduction fluid is defined between the heat conduction side wall (131; 231) and the inner side wall (112; 212) of the base (110; 210).

3. The dynamic heat conduction system (100; 200; 300) of claim 2, wherein the heat conduction block (130; 230) has at least one groove (134; 234) on the heat conduction side wall (131; 231) for accommodating the heat conduction fluid.

4. The dynamic heat conduction system (200; 300) according to at least one of claims 1 to 3, wherein the heat conduction block (230) has a hole penetrating the heat conduction block (230) and forming the at least two heat conduction block securing holes (233) on the heat conduction side wall (231).

5. A dynamic heat conduction system (300), comprising:
a heat conduction board (310) covering a plurality of electronic components;
a plurality of bases (110; 210) disposed respectively on the heat conduction board (310) at positions corresponding to the electronic components and respectively comprising a base surface (111; 211) and an inner side wall (112; 212) which defines at least two base securing holes (113; 213) having a base securing hole length (L2; L2') along the direction of a normal line to the base surface (111; 211);
a plurality of heat conduction blocks (130; 230) disposed respectively in the bases (110; 210) and respectively comprising a heat conduction side wall (131; 231) and a heat conduction surface (132; 232), the heat conduction side walls (131; 231) respectively being opposite to the inner side wall (112; 212) of the bases (110; 210) and defining at least two heat conduction block securing holes (133; 233) at positions respectively corresponding to those of the base securing holes (113; 213), the heat conduction block securing holes (133; 233) respectively having a heat conduction block (130; 230) securing hole length along the direction of a normal line to the base surface (111; 211) of the bases (110; 210);
a plurality of resilient units disposed respectively in the bases (110; 210) and respectively having one end being disposed on the base surface (111; 211) of the bases (110; 210) and the other end respectively being opposite to the base surface (111; 211) of the bases (110; 210) and being engaged with the heat conduction blocks (130; 230), so that the heat conduction blocks (130; 230) are disposed respectively in the bases (110; 210) and the heat conduction surfaces (132; 232) remain outside the bases (110; 210); and
a plurality of securing units (140; 240) disposed respectively in the bases (110; 210), respectively having at least one portion being secured to the heat conduction block securing holes (133; 233) and at least another portion being disposed in the base securing holes (113; 213), and respectively having a securing unit width (L1; L1') along the direction of a normal line to the base surface (111; 211) of the bases (110; 210) respectively,
wherein the base securing holes length (L2; L2') are greater respectively than the securing units width (L1; L1') and the securing units width (L1; L1') are greater respectively than or equal to the heat conduction block securing holes length (L3; L3') so that the heat conduction blocks (130; 230) are movable in the direction of a normal line to the heat conduction surface (132; 232) respectively and at least one portion thereof is restricted within the bases (110; 210).

6. The dynamic heat conduction system (300) of claim 5, wherein gaps (114; 214) respectively accommodating a heat conduction fluid is defined between the heat conduction side walls (131; 231) and the inner side wall (112; 212) of the bases (110; 210).

7. The dynamic heat conduction system (300) of claim 6, wherein the heat conduction blocks (130; 230) respectively have at least one groove (134; 234) on the heat conduction side walls (131; 231) for accommodating the heat conduction fluid.

8. The dynamic heat conduction system (300) according to one of claims 5 to 7, wherein the heat conduction blocks (130; 230) respectively have a hole penetrating the heat conduction blocks (130; 230) and forming the at least two heat conduction block securing holes (133; 233) on the heat conduction side walls (131; 231) respectively.

9. The dynamic heat conduction system (300) according to one of claims 5 to 8, wherein the bases (110; 210) have different heights respectively corresponding to that of each the electronic components.

10. The dynamic heat conduction system (300) according to one of claims 5 to 9, wherein the heat conduction blocks (130; 230) have different heights respectively corresponding to that of each the electronic components.

11. The dynamic heat conduction system (300) according to one of claims 5 to 10, wherein the resilient units (120) have different heights or different resilient coefficients respectively corresponding to that of each the electronic components.

12. The dynamic heat conduction system (300) according to one of claims 5 to 11, wherein the bases (110; 210) have different shedding surface areas respectively corresponding to a contact surface area of each the electronic components and the heat conduction blocks (130; 230) have different heat conduction surface (132; 232) areas respectively corresponding to each the contact surfaces, and the resilient units have different resilient unit areas respectively corresponding to each the shedding surface areas.

13. The dynamic heat conduction system (300) according to one of claims 5 to 12, wherein the bases (110; 210) are welded with a post processing nickel and the heat conduction board (310).

14. The dynamic heat conduction system (300) according to one of claims 5 to 13, wherein the bases (110; 210) are secured on the heat conduction boards (310) with screws.

## Patentansprüche

1. Dynamisches Wärmeleitungssystem (100; 200; 300), das umfasst:
eine Basis (110; 210) mit einer Basisoberfläche (111; 211) und einer Innenseitenwand (112; 212), die mindestens zwei Basisbefestigungslöcher (113; 213) mit einer Basisbefestigungslochlänge (L2; L2') entlang der Richtung einer normalen Linie zur Basisoberfläche (111; 211) definiert;
einen Wärmeleitungsblock (130; 230) mit einer Wärmeleitungsseitenwand (131; 231) und einer Wärmeleitungsoberfläche (132; 232), wobei die Wärmeleitungsseitenwand (131; 231) der Innenseitenwand (112; 212) der Basis gegenüberliegt und mindestens zwei Wärmeleitungsblockbefestigungslöcher (133; 233) in Positionen definiert, die jeweils jenen der Basisbefestigungslöcher (113; 213) entsprechen, wobei die Wärmeleitungsblockbefestigungslöcher (133; 233) eine Wärmeleitungsblockbefestigungslochlänge (L3) entlang der Richtung einer normalen Linie zur Basisoberfläche (111; 211) der Basis (110; 210) aufweisen;
eine elastische Einheit (120; 220), deren eines Ende an der Basisoberfläche (111; 211) der Basis (110; 210) angeordnet ist und deren anderes Ende zur Basisoberfläche (111; 211) der Basis (110; 210) entgegengesetzt ist und mit dem Wärmeleitungsblock (130; 230) in Eingriff steht, so dass der Wärmeleitungsblock (130; 230) in der Basis (110; 210) angeordnet ist und die Wärmeleitungsoberfläche (132; 232) außerhalb der Basis (110; 210) bleibt; und
mindestens eine Befestigungseinheit (140; 240), von der mindestens ein Abschnitt jeweils an den Wärmeleitungsblockbefestigungslöchern (133; 233) befestigt ist und mindestens ein anderer der anderen Abschnitte jeweils in den Basisbefestigungslöchern (113; 213) angeordnet ist, wobei die Befestigungseinheit (140; 240) eine Befestigungseinheitsbreite (L1; L1') entlang der Richtung einer normalen Linie zur Basisoberfläche (111; 211) der Basis (110; 210) aufweist,
wobei die Basisbefestigungslochlänge (L2; L2') größer ist als die Befestigungseinheitsbreite (L1; L1') und die Befestigungseinheitsbreite (L1; L1') größer als oder gleich der Wärmeleitungsblockbefestigungslochlänge (L3) ist, so dass der Wärmeleitungsblock (130; 230) in der Richtung einer normalen Linie zur Wärmeleitungsoberfläche (132; 232) beweglich ist und mindestens ein Abschnitt davon innerhalb der Basis (110, 210) eingeschränkt ist.

2. Dynamisches Wärmeleitungssystem (100; 200; 300) nach Anspruch 1, wobei ein Spalt (114; 214), der ein Wärmeleitungsfluid aufnimmt, zwischen der Wärmeleitungsseitenwand (131; 231) und der Innenseitenwand (112; 212) der Basis (110; 210) definiert ist.

3. Dynamisches Wärmeleitungssystem (100; 200; 300) nach Anspruch 2, wobei der Wärmeleitungsblock (130; 230) mindestens eine Nut (134; 234) an der Wärmeleitungsseitenwand (131; 231) zum Aufnehmen des Wärmeleitungsfluids aufweist.

4. Dynamisches Wärmeleitungssystem (200; 300) nach mindestens einem der Ansprüche 1 bis 3, wobei der Wärmeleitungsblock (230) ein Loch aufweist, das den Wärmeleitungsblock (230) durchdringt und die mindestens zwei Wärmeleitungsblockbefestigungslöcher (233) an der Wärmeleitungsseitenwand (231) bildet.

5. Dynamisches Wärmeleitungssystem (300), das umfasst:
eine Wärmeleitungsplatine (310), die eine Vielzahl von elektronischen Bauteilen bedeckt;
eine Vielzahl von Basen (110; 210), die jeweils auf der Wärmeleitungsplatine (310) in Positionen angeordnet sind, die den elektronischen Bauteilen entsprechen, und jeweils eine Basisoberfläche (111; 211) und eine Innenseitenwand (112; 212) umfassen, die mindestens zwei Basisbefestigungslöcher (113; 213) mit einer Basisbefestigungslochlänge (L2; L2') entlang der Richtung einer normalen Linie zur Basisoberfläche (111; 211) definiert;
eine Vielzahl von Wärmeleitungsblöcken (130; 230), die jeweils in den Basen (110; 210) angeordnet sind und jeweils eine Wärmeleitungsseitenwand (131; 231) und eine Wärmeleitungsoberfläche (132; 232) umfassen, wobei die Wärmeleitungsseitenwände (131; 231) jeweils der Innenseitenwand (112; 212) der Basen (110; 210) gegenüberliegen und mindestens zwei Wärmeleitungsblockbefestigungslöcher (133; 233) in Positionen definieren, die jeweils jenen der Basisbefestigungslöcher (113; 213) entsprechen, wobei die Wärmeleitungsblockbefestigungslöcher (133; 233) eine Befestigungslochlänge des Wärmeleitungsblocks (130; 230) entlang der Richtung einer normalen Linie zur Basisoberfläche (111; 211) der Basen (110; 210) aufweisen;
eine Vielzahl von elastischen Einheiten, die jeweils in den Basen (110; 210) angeordnet sind und von denen jeweils ein Ende an der Basisoberfläche (111; 211) der Basen (110; 210) angeordnet ist und das andere Ende jeweils zur Basisoberfläche (111; 211) der Basen (110; 210) entgegengesetzt ist und mit den Wärmeleitungsblöcken (130; 230) in Eingriff steht, so dass die Wärmeleitungsblöcke (130; 230) jeweils in den Basen (110; 210) angeordnet sind und die Wärmeleitungsoberflächen (132; 232) außerhalb der Basen (110; 210) bleiben; und
eine Vielzahl von Befestigungseinheiten (140; 240), die jeweils in den Basen (110; 210) angeordnet sind, von denen jeweils mindestens ein Abschnitt an den Wärmeleitungsblockbefestigungslöchern (133; 233) befestigt ist und mindestens ein anderer Abschnitt in den Basisbefestigungslöchern (113; 213) angeordnet ist, und jeweils eine Befestigungseinheitsbreite (L1; L1') entlang der Richtung einer normalen Linie zur Basisoberfläche (111; 211) jeweils der Basen (110; 210) aufweisen,
wobei die Basisbefestigungslochlängen (L2; L2') jeweils größer sind als die Befestigungseinheitsbreite (L1; L1') und die Befestigungseinheitsbreiten (L1; L1') jeweils größer als oder gleich der Wärmeleitungsblockbefestigungslochlänge (L3') sind, so dass die Wärmeleitungsblöcke (130; 230) jeweils in der Richtung einer normalen Linie zur Wärmeleitungsoberfläche (132; 232) beweglich sind und mindestens ein Abschnitt davon innerhalb der Basen (110; 210) eingeschränkt ist.

6. Dynamisches Wärmeleitungssystem (300) nach Anspruch 5, wobei Spalte (114; 214), die jeweils ein Wärmeleitungsfluid aufnehmen, zwischen den Wärmeleitungsseitenwänden (131; 231) und der Innenseitenwand (112; 212) der Basen (110; 210) definiert sind.

7. Dynamisches Wärmeleitungssystem (300) nach Anspruch 6, wobei die Wärmeleitungsblöcke (130; 230) jeweils mindestens eine Nut (134; 234) an den Wärmeleitungsseitenwänden (131; 231) zum Aufnehmen des Wärmeleitungsfluids aufweisen.

8. Dynamisches Wärmeleitungssystem (300) nach einem der Ansprüche 5 bis 7, wobei die Wärmeleitungsblöcke (130; 230) jeweils ein Loch aufweisen, das die Wärmeleitungsblöcke (130; 230) durchdringt und jeweils die mindestens zwei Wärmeleitungsblockbefestigungslöcher (133; 233) an den Wärmeleitungsseitenwänden (131; 231) bildet.

9. Dynamisches Wärmeleitungssystem (300) nach einem der Ansprüche 5 bis 8, wobei die Basen (110; 210) verschiedene Höhen aufweisen, die jeweils jener von jedem der elektronischen Bauteile entsprechen.

10. Dynamisches Wärmeleitungssystem (300) nach einem der Ansprüche 5 bis 9, wobei die Wärmeleitungsblöcke (130; 230) verschiedene Höhen aufweisen, die jeweils jener von jedem der elektronischen Bauteile entsprechen.

11. Dynamisches Wärmeleitungssystem (300) nach einem der Ansprüche 5 bis 10, wobei die elastischen Einheiten (120) verschiedene Höhen oder verschiedene Elastizitätskoeffizienten aufweisen, die jeweils jener von jedem der elektronischen Bauteile entsprechen.

12. Dynamisches Wärmeleitungssystem (300) nach einem der Ansprüche 5 bis 11, wobei die Basen (110; 210) verschiedene Ableitungsoberflächenbereiche aufweisen, die jeweils einem Kontaktoberflächenbereich von jedem der elektronischen Bauteile entsprechen, und die Wärmeleitungsblöcke (130; 230) verschiedene Bereiche der Wärmeleitungsoberfläche (132; 232) aufweisen, die jeweils jeder der Kontaktoberflächen entsprechen, und die elastischen Einheiten verschiedene Bereiche der elastischen Einheiten aufweisen, die jeweils jedem der Ableitungsoberflächenbereiche entsprechen.

13. Dynamisches Wärmeleitungssystem (300) nach einem der Ansprüche 5 bis 12, wobei die Basen (110; 210) mit einem Nachverarbeitungsnickel und der Wärmeleitungsplatine (310) verschweißt sind.

14. Dynamisches Wärmeleitungssystem (300) nach einem der Ansprüche 5 bis 13, wobei die Basen (110; 210) an den Wärmeleitungsplatinen (310) mit Schrauben befestigt sind.

## Revendications

1. Système de conduction thermique dynamique (100 ; 200 ; 300), comprenant :
une base (110; 210) comprenant une surface de base (111 ; 211) et une paroi latérale intérieure (112 ; 212) qui définit au moins deux trous de fixation de base (113 ; 213) ayant une longueur de trou de fixation de base (L2 ; L2') le long de la direction d'une ligne perpendiculaire à la surface de base (111 ; 211) ;
un bloc de conduction thermique (130 ; 230) comprenant une paroi latérale de conduction thermique (131 ; 231) et une surface de conduction thermique (132 ; 232), la paroi latérale de conduction thermique (131 ; 231) étant opposée à la paroi latérale intérieure (112 ; 212) de la base et définissant au moins deux trous de fixation de bloc de conduction thermique (133 ; 233) dans des positions correspondant respectivement à celles des trous de fixation de base (113 ; 213), les trous de fixation de bloc de conduction thermique (133 ; 233) ayant une longueur de trou de fixation de bloc de conduction thermique (L3) le long de la direction d'une ligne perpendiculaire à la surface de base (111 ; 211) de la base (110 ; 210) ;
une unité résiliente (120 ; 220) ayant une extrémité disposée sur la surface de base (111 ; 211) de la base (110 ; 210) et l'autre extrémité étant opposée à la surface de base (111 ; 211) de la base (110 ; 210) et étant en prise avec le bloc de conduction thermique (130 ; 230), de telle sorte que le bloc de conduction thermique (130 ; 230) est disposé dans la base (110 ; 210) et la surface de conduction thermique (132 ; 232) reste à l'extérieur de la base (110 ; 210) ; et
au moins une unité de fixation (140 ; 240) ayant au moins une portion fixée aux trous de fixation de bloc de conduction thermique (133 ; 233) respectivement et au moins une autre des autres portions étant disposée dans les trous de fixation de base (113 ; 213) respectivement, l'unité de fixation (140 ; 240) ayant une largeur d'unité de fixation (L1 ; L1') le long de la direction d'une ligne perpendiculaire à la surface de base (111 ; 211) de la base (110 ; 210),
dans lequel la longueur de trou de fixation de base (L2 ; L2') est supérieure à la largeur d'unité de fixation (L1 ; L1') et la largeur d'unité de fixation (L1 ; L1') est supérieure ou égale à la longueur de trou de fixation de bloc de conduction thermique (L3), de telle sorte que le bloc de conduction thermique (130 ; 230) est mobile dans la direction d'une ligne perpendiculaire à la surface de conduction thermique (132 ; 232) et au moins une portion de celui-ci est limitée dans la base (110, 210).

2. Système de conduction thermique dynamique (100 ; 200 ; 300) selon la revendication 1, dans lequel un espace (114 ; 214) accueillant un fluide de conduction thermique est défini entre la paroi latérale de conduction thermique (131 ; 231) et la paroi latérale intérieure (112 ; 212) de la base (110 ; 210).

3. Système de conduction thermique dynamique (100 ; 200 ; 300) selon la revendication 2, dans lequel le bloc de conduction thermique (130 ; 230) comporte au moins une rainure (134 ; 234) sur la paroi latérale de conduction thermique (131 ; 231) pour accueillir le fluide de conduction thermique.

4. Système de conduction thermique dynamique (200 ; 300) selon au moins une des revendications 1 à 3, dans lequel le bloc de conduction thermique (230) comporte un trou pénétrant dans le bloc de conduction thermique (230) et formant les au moins deux trous de fixation de bloc de conduction thermique (233) sur la paroi latérale de conduction thermique (231).

5. Système de conduction thermique dynamique (300), comprenant :
une planche de conduction thermique (310) couvrant une pluralité de composants électroniques ;
une pluralité de bases (110 ; 210) disposées respectivement sur la planche de conduction thermique (310) dans des positions correspondant aux composants électroniques et comprenant respectivement une surface de base (111 ; 211) et une paroi latérale intérieure (112 ; 212) qui définit au moins deux trous de fixation de base (113 ; 213) ayant une longueur de trou de fixation de base (L2 ; L2') le long de la direction d'une ligne perpendiculaire à la surface de base (111 ; 211) ;
une pluralité de blocs de conduction thermique (130 ; 230) disposés respectivement dans les bases (110 ; 210) et comprenant respectivement une paroi latérale de conduction thermique (131 ; 231) et une surface de conduction thermique (132 ; 232), paroi latérale de conduction thermique (131 ; 231) étant respectivement opposée à la paroi latérale intérieure (112 ; 212) des bases (110 ; 210) et définissant au moins deux trous de fixation de bloc de conduction thermique (133 ; 233) dans des positions correspondant respectivement à celles des trous de fixation de base (113 ; 213), les trous de fixation de bloc de conduction thermique (133 ; 233) ayant respectivement une longueur de trou de fixation de bloc de conduction thermique (130 ; 230) le long de la direction d'une ligne perpendiculaire à la surface de base (111 ; 211) des bases (110 ; 210) ;
une pluralité d'unités résilientes disposées respectivement dans les bases (110 ; 210) et ayant respectivement une extrémité disposée sur la surface de base (111 ; 211) des bases (110 ; 210) et l'autre extrémité étant opposée à la surface de base (111 ; 211) des bases (110 ; 210) et étant en prise avec les blocs de conduction thermique (130 ; 230), de telle sorte que les blocs de conduction thermique (130 ; 230) sont disposés respectivement dans les bases (110 ; 210) et les surfaces de conduction thermique (132 ; 232) restent à l'extérieur des bases (110 ; 210) ; et
une pluralité d'unités de fixation (140 ; 240) disposées respectivement dans les bases (110 ; 210), ayant respectivement au moins une portion fixée aux trous de fixation de bloc de conduction thermique (133 ; 233) et au moins une autre portion disposée dans les trous de fixation de base (113 ; 213), et ayant respectivement une largeur d'unité de fixation (L1 ; L1') le long de la direction d'une ligne perpendiculaire à la surface de base (111 ; 211) des bases (110, 210) respectivement,
dans lequel les longueurs de trous de fixation de base (L2 ; L2') sont supérieures respectivement aux largeurs d'unités de fixation (L1 ; L1') et les largeurs d'unités de fixation (L1 ; L1') sont respectivement supérieures ou égales aux longueurs de trous de fixation de bloc de conduction thermique (L3 ; L3') de telle sorte que les blocs de conduction thermique (130 ; 230) sont mobiles dans la direction d'une ligne perpendiculaire à la surface de conduction thermique (132 ; 232) respectivement et au moins une portion de ceux-ci est limitée dans les bases (110 ; 210).

6. Système de conduction thermique dynamique (300) selon la revendication 5, dans lequel des espaces (114 ; 214) logeant respectivement un fluide de conduction thermique sont définis entre les parois latérales de conduction thermique (131 ; 231) et la paroi latérale intérieure (112 ; 212) des bases (110 ; 210).

7. Système de conduction thermique dynamique (300) selon la revendication 6, dans lequel les blocs de conduction thermique (130 ; 230) comportent respectivement au moins une rainure (134 ; 234) sur les parois latérales de conduction thermique (131 ; 231) pour loger le fluide de conduction thermique.

8. Système de conduction thermique dynamique (300) selon l'une des revendications 5 à 7, dans lequel les blocs de conduction thermique (130 ; 230) comportent respectivement un trou pénétrant dans les blocs de conduction thermique (130 ; 230) et formant les au moins deux trous de fixation de bloc de conduction thermique (133 ; 233) sur les parois latérales de conduction thermique (131 ; 231) respectivement.

9. Système de conduction thermique dynamique (300) selon l'une des revendications 5 à 8, dans lequel les bases (110 ; 210) ont différentes hauteurs correspondant respectivement à celle de chacun des composants électroniques.

10. Système de conduction thermique dynamique (300) selon l'une des revendications 5 à 9, dans lequel les blocs de conduction thermique (130 ; 230) ont différentes hauteurs correspondant respectivement à celle de chacun des composants électroniques.

11. Système de conduction thermique dynamique (300) selon l'une des revendications 5 à 10, dans lequel les unités résilientes (120) ont différentes hauteurs ou différents coefficients de résilience correspondant respectivement à celui de chacun des composants électroniques.

12. Système de conduction thermique dynamique (300) selon l'une des revendications 5 à 11, dans lequel les bases (110 ; 210) ont différentes zones de surface de perte correspondant respectivement à une zone de contact de chacun des composants électroniques et les blocs de conduction thermique (130 ; 230) ont différentes zones de surface de conduction thermique (132 ; 232) correspondant respectivement à chacune des surfaces de contact, et les unités résilientes ont différentes zones d'unité résiliente correspondant respectivement à chacune des zones de surface de perte.

13. Système de conduction thermique dynamique (300) selon l'une des revendications 5 à 12, dans lequel les bases (110 ; 210) sont soudées avec un nickel de post-traitement et la planche de conduction thermique (310).

14. Système de conduction thermique dynamique (300) selon l'une des revendications 5 à 13, dans lequel les bases (110 ; 210) sont fixées sur les planches de conduction thermique (310) avec des vis.
